(19) Europäisches Patentamt
European Patent Office
Office européen des brevets

(11)  **EP 1 111 786 B1**

(12)  **FASCICULE DE BREVET EUROPEEN**

(45) Date de publication et mention
de la délivrance du brevet:
**07.01.2009  Bulletin 2009/02**

(51) Int Cl.:
***H03K 17/16*** *(2006.01)*

(21) Numéro de dépôt: **00125549.6**

(22) Date de dépôt: **22.11.2000**

(54)  **Circuit intégré comprenant un transistor de sortie ayant un temps de passage à zéro contrôlé**

Einen Ausgangstransistor mit gesteuerter Abfallzeit enthaltende integrierte Schaltung

Integrated circuit comprising an output transistor having a controlled fall time

(84) Etats contractants désignés:
**DE FR GB IT**

(30) Priorité:  **23.12.1999  FR 9916563**

(43) Date de publication de la demande:
**27.06.2001  Bulletin 2001/26**

(73) Titulaire: **STMicroelectronics SA**
**F-92120 Montrouge (FR)**

(72) Inventeurs:
• **Bertrand, Bertrand**
**13530 Trets (FR)**
• **Devin, Jean**
**13100 Le Tholonet (FR)**

(74) Mandataire: **Marchand, André**
**OMNIPAT,**
**24 Place des Martyrs de la Résistance**
**13100 Aix-en-Provence (FR)**

(56) Documents cités:
**EP-A- 0 788 232       US-A- 4 318 014**
**US-A- 5 216 294**

• **"OFF-CHIP DRIVER FOR SMALL COMPUTER SYSTEM INTERFACE" IBM TECHNICAL DISCLOSURE BULLETIN,US,IBM CORP. NEW YORK, vol. 37, no. 5, 1 mai 1994 (1994-05-01), pages 239-240, XP000453146 ISSN: 0018-8689**

**Description**

La présente invention concerne le contrôle des caractéristiques électriques d'un transistor de sortie dans un circuit intégré.

La présente invention concerne notamment le contrôle du point de fonctionnement à l'état bas et le contrôle du temps de passage à l'état bas d'un transistor de sortie de type MOS connecté à un bus de données présentant une capacité parasite.

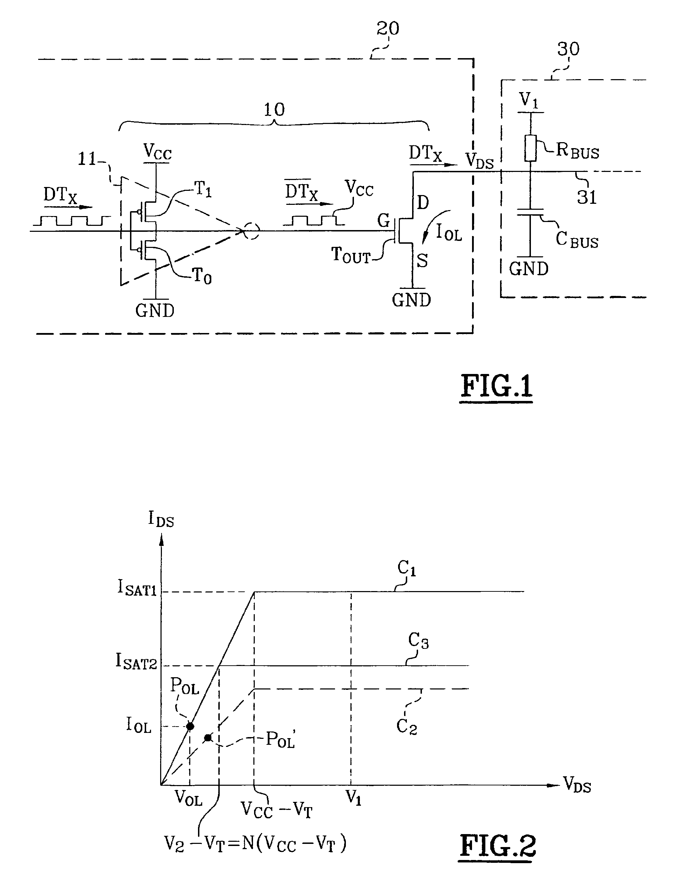

Pour fixer les idées, la figure 1 représente schématiquement l'étage de sortie classique 10 d'un circuit intégré 20 de technologie CMOS, connecté à l'entrée d'un bus de données 30 de type I2C. L'étage de sortie 10 comprend une porte inverseuse 11 dont la sortie pilote la grille d'un transistor de sortie $T_{OUT}$, ici un transistor NMOS. La porte inverseuse 11 comprend un transistor PMOS T1 et un transistor NMOS T0 connectés par leurs drains. La source du transistor PMOS T1 reçoit la tension $V_{CC}$ d'alimentation du circuit intégré 20 et la source du transistor NMOS T0 est connectée à la masse (GND). La porte inverseuse 11 reçoit en entrée (grille des transistors T0, T1) des données binaires DTx à émettre sur le bus 30, et délivre des données inversées /DTx sur la grille G du transistor de sortie $T_{OUT}$, Un bit à "1" à la sortie de la porte inverseuse 11 correspond à l'application de la tension $V_{cc}$ sur la grille du transistor $T_{OUT}$ (transistor T1 passant) et un bit à "0" correspond à la connexion de la grille du transistor $T_{OUT}$ à la masse (transistor T0 passant).

Le transistor $T_{OUT}$ est connecté par son drain D à la ligne de transmission de données 31 du bus 30 et sa source S est connectée à la masse. Le bus 30 vu de son entrée présente une capacité parasite $C_{BUS}$ entre la ligne de transmission 31 et la masse. Lorsque le transistor $T_{OUT}$ est dans l'état bloqué, la ligne 31 est maintenue par défaut à "1" par une résistance de polarisation $R_{BUS}$, ou résistance "pull-up", recevant à son autre extrémité une tension de polarisation V1. En pratique, la tension V1 peut être égale à $V_{CC}$ et est par exemple de l'ordre de 5V.

Lorsque le transistor $T_{OUT}$ reçoit un bit à "1" sur sa grille (tension $V_{cc}$), le transistor $T_{OUT}$ devient passant, la capacité $C_{BUS}$ se décharge et la sortie de l'étage 10 passe à "0". Le temps de décharge est désigné $T_{FALL}$. Le "0" en sortie correspond à une tension drain-source $V_{DS}$ et un courant drain-source $I_{DS}$ ayant des valeurs stables désignées respectivement $V_{OL}$ et $I_{OL}$ et définissant le point de fonctionnement à l'état bas du transistor $T_{OUT}$. Pour des raisons historiques tenant à l'utilisation de transistors bipolaires dans les étages d'entrée ou de sortie des circuits intégrés, les spécifications industrielles des bus I2C imposent une tension $V_{OL}$ assez basse de l'ordre de 0,2 à 0,4 V et un courant $I_{OL}$ assez fort de l'ordre de 0,7 à 3 mA. Avec la technologie MOS, un tel point de fonctionnement ne peut être atteint qu'avec un transistor NMOS ayant une largeur W de grille très supérieure à la longueur L de grille, soit un rapport W/L nettement supérieur à 1.

Le courant de saturation $I_{SAT}$ d'un transistor MOS étant proportionnel au rapport W/L, le transistor $T_{OUT}$ est ainsi traversé par un courant important pendant sa commutation, la capacité $C_{BUS}$ se décharge de façon quasi instantanée et le temps $T_{FALL}$ de passage à "0" est très court. Or, le fait que le temps $T_{FALL}$ soit très court génère dans la ligne de transmission 31 un bruit électronique indésirable. Il est donc souhaitable que le temps $T_{FALL}$ soit allongé et soit au moins de l'ordre de 20 ns.

Toutefois, dans un étage de sortie 10 tel que décrit ci-dessus, l'obtention d'un temps $T_{FALL}$ assez long est incompatible avec l'obtention d'une tension $V_{OL}$ faible et d'un courant $I_{OL}$ assez fort. En effet, la décharge de la capacité $C_{BUS}$ est essentiellement assurée par le courant du transistor à l'état saturé, ou courant $I_{SAT}$. Ainsi, si l'on diminue le rapport W/L du transistor pour limiter le courant $I_{SAT}$ de décharge de la capacité $C_{BUS}$, on augmente en même temps la tension $V_{OL}$ et on affaiblit le courant $I_{OL}$.

La présente invention vise à pallier cet inconvénient.

Plus particulièrement, un objectif de la présente invention est de prévoir un procédé permettant d'allonger le temps $T_{FALL}$ de passage à "0" d'un transistor de sortie du type décrit ci-dessus, sans modifier son point de fonctionnement $V_{OL}$, $I_{OL}$ à l'état bas.

Un autre objectif de la présente invention est de prévoir un étage de sortie du type précité comprenant un moyen de contrôle du temps de descente du transistor de sortie, lorsqu'il est connecté à un bus de données capacitif.

Ces objectifs sont atteints par un procédé pour allonger le temps de passage à zéro d'une borne d'un transistor de sortie de type MOS selon revendication 1.

Selon un mode de réalisation, le procédé comprend une étape consistant à connecter la grille du transistor à un circuit de polarisation de grille.

Selon un mode de réalisation, le circuit de polarisation de grille est agencé pour réduire la tension à l'état haut délivrée par le circuit logique sur la grille du transistor.

Selon un mode de réalisation, le circuit de polarisation de grille comprend au moins en série un premier transistor MOS monté en diode, sensiblement identique au transistor de sortie, et un transistor natif également agencé en diode.

Selon un mode de réalisation, on applique au transistor de sortie une tension de polarisation grille-source inférieure à 2 Volt pour rendre le transistor passant.

La présente invention concerne également un circuit intégré selon la revendication 6.

Selon un mode de réalisation, la tension de polarisation grille-source du transistor à l'état passant est inférieure à 2 Volt.

Selon un mode de réalisation, le circuit de polarisation comprend un transistor natif agencé en diode, en série avec le premier transistor diode.

Selon un mode de réalisation, le transistor de sortie présente un rapport largeur sur longueur de grille lui conférant un point de fonctionnement à l'état bas conforme aux spécifications des bus I2C et un temps de descente du signal de sortie au moins égal à 20 nanosecondes.

En pratique, le circuit intégré peut prendre la forme d'une mémoire EEPROM et l'étage de sortie être agencé pour délivrer des données lues dans la mémoire.

Ces objets, caractéristiques et avantages de la présente invention seront exposés plus en détail dans la description suivante du procédé selon l'invention et d'un exemple de réalisation d'un étage de sortie selon l'invention, précédée d'une analyse détaillée du problème technique évoqué au préambule et faite à titre non limitatif en relation avec les figures jointes parmi lesquelles :

- la figure 1 précédemment décrite représente l'étage de sortie série classique d'un circuit intégré,
- la figure 2 représente des courbes courant/tension de transistors de sortie classiques et une courbe courant/tension d'un transistor de sortie selon l'invention,
- la figure 3 représente schématiquement un étage de sortie selon l'invention,
- la figure 4 représente un exemple de réalisation d'un circuit de polarisation selon l'invention, et
- la figure 5 représente schématiquement une mémoire EEPROM et illustre une application de la présente invention.

**Analyse du problème technique**

Comme cela est indiqué au préambule, l'obtention d'un temps $T_{FALL}$ assez long dans l'étage de sortie 10 représenté en figure 1 est en pratique incompatible avec l'obtention d'un point de fonctionnement comprenant une tension $V_{OL}$ assez faible et un courant $I_{OL}$ assez fort.

Ce paradoxe sera mieux compris en se référant à la figure 2, qui représente la courbe courant/tension $I_{DS}$=f$(V_{DS})$ du transistor de sortie $T_{OUT}$. Lorsque la grille du transistor $T_{OUT}$ reçoit la tension $V_{CC}$ délivrée par le transistor T1 de la porte inverseuse 11 (figure 1), le transistor $T_{OUT}$ s'ouvre progressivement en passant de l'état saturé à l'état linéaire et sa tension drain-source $V_{DS}$ glisse sur la courbe C1 à partir de sa valeur initiale, qui est la tension $V_1$ de polarisation du bus 31, jusqu'à la valeur $V_{OL}$. Pendant la première partie de la période de décharge de la capacité $C_{BUS}$, le transistor est dans l'état saturé car la tension $V_{DS}$ est supérieure à la tension différentielle de grille $V_{GS}-V_T$. Le courant $I_{DS}$, classiquement désigné $I_{SAT}$, est constant et obéit à la relation classique :

$$(1) \quad I_{DS} \; = \; I_{SAT} \; = \; (K_P/2)\,(W/L)\,(V_{GS}-V_T)^2$$

dans laquelle $K_P$ est une constante (mobilité des porteurs), $V_T$ est la tension de seuil du transistor et $V_{GS}$ la tension de grille. La tension de grille $V_{GS}$ étant égale à $V_{CC}$, la relation (1) peut aussi s'écrire :

$$(2) \quad I_{DS} \; = \; I_{SAT} \; = \; (K_P/2)\,(W/L)\,(V_{CC}-V_T)^2$$

Pendant la deuxième partie de la période de décharge, la tension $V_{DS}$ devient inférieure à la tension différentielle de grille $V_{CC}-V_T$. Le transistor $T_{OUT}$ fonctionne alors en régime linéaire et le courant drain-source $I_{DS}$ obéit à la relation classique :

$$(3) \quad I_{DS} \; = \; K_P \; (W/L)\,(V_{CC}-V_T)\,V_{DS}$$

Lorsque la capacité $C_{BUS}$ est entièrement déchargée, le transistor présente le point de fonctionnement $P_{OL}$ représenté sur la figure 2, défini par les valeurs particulières $I_{OL}$ et $V_{OL}$ de son courant drain-source $I_{DS}$ et de sa tension drain-source $V_{DS}$. Au point de fonctionnement $P_{OL}$ la relation (3) peut s'écrire :

$$(4) \quad I_{OL} = K_P \ (W/L) \ (V_{CC}-V_T) \ V_{OL}$$

Au point de fonctionnement $P_{OL}$, la tension aux bornes de la résistance $R_{BUS}$ et la tension aux bornes du transistor $T_{OUT}$ sont liées par la relation suivante :

$$(5) \quad V_1 = R_{BUS} \ I_{OL} + V_{OL}$$

soit, en combinant les relations (4) et (5) :

$$(6) \quad V_1 = R_{BUS} \ I_{OL} + I_{OL}/[K_P \ (W/L) \ (V_{CC}-V_T)]$$

On en déduit la valeur de $I_{OL}$ :

$$(7) \quad I_{OL} = V_1/[R_{BUS} + 1/[K_P \ (W/L) \ (V_{CC}-V_T)]]$$

En combinant les relations (5) et (7), on en déduit également la valeur de $V_{OL}$ :

$$(8) \quad V_{OL} = V_1/[1+(R_{BUS} \ K_P \ (W/L) \ (V_{CC}-V_T))]$$

Dans les relations (7) et (8), les paramètres $V_1$, $V_{CC}$, $R_{BUS}$ sont imposés par l'environnement du transistor de sortie $T_{OUT}$. Pour allonger le temps $T_{FALL}$, une solution pourrait consister à diminuer le rapport W/L du transistor. Cela permettrait de limiter le courant $I_{SAT}$ de décharge de la capacité $C_{BUS}$ pendant la période de saturation (relation 2) et le courant $I_{DS}$ pendant la période linéaire (relation 3). Toutefois, les relations (7) et (8) montrent aussi qu'une diminution du paramètre W/L entraînerait une nette augmentation de la tension $V_{OL}$ et une faible diminution du courant $I_{OL}$. Le point de fonctionnement $P_{OL}$ glisserait donc vers un point de fonctionnement $P_{OL}'$ sur une courbe C2' représentée sur la figure 2, ne satisfaisant pas les spécifications industrielles devant être respectées.

En définitive, le point de fonctionnement $P_{OL}$ prévu par les spécifications industrielles impose le rapport W/L du transistor et impose ainsi le courant de saturation $I_{SAT}$. La prévision d'une tension $V_{OL}$ et d'un courant $I_{OL}$ conformes aux spécifications est contradictoire avec l'obtention d'un temps de décharge $T_{FALL}$ plus long qui permettrait de diminuer le bruit de commutation.

**Procédé selon l'invention**

La présente invention propose de diminuer le courant de saturation $I_{SAT}$ du transistor de sortie $T_{OUT}$ sans décaler le point de fonctionnement $P_{OL}$, en abaissant la tension $V_{GS}$ de polarisation de la source du transistor $T_{OUT}$ tout en augmentant le rapport W/L (au lieu de le diminuer). Avant de décrire un exemple de mise en oeuvre de ce procédé, on vérifiera préalablement la faisabilité du procédé du point de vue théorique.

Le courant $I_{OL1}$ et le courant de saturation $I_{SAT1}$ du transistor classique $T_{OUT}$ sont donnés par les relations (9) et (10) ci-après, dans lesquelles on désigne par $I_{OL1}$, $V_{OL1}$, $W_1/L_1$, $I_{SAT1}$ les caractéristiques précédemment désignées $I_{OL}$, $V_{OL}$, W/L, $I_{SAT}$.

$$(9) \quad I_{OL1} = K_P \ (W_1/L_1) \ (V_{CC}-V_T) \ V_{OL1}$$

$$(10) \quad I_{SAT1} = (K_P/2) \ (W_1/L_1) \ (V_{CC}-V_T)^2$$

Par ailleurs, les relations (11) et (12) ci-après concernent respectivement le courant $I_{OL2}$ et le courant de saturation $I_{SAT2}$ d'un transistor selon l'invention, polarisé sur sa grille au moyen d'une tension $V_2$ différente de $V_{CC}$ et toujours polarisé sur son drain par la tension V1 du bus 30.

$$(11) \quad I_{OL2} = K_P \ (W_2/L_2)(V_2 - V_T) V_{OL2}$$

$$(12) \quad I_{SAT2} = (K_P/2)(W_2/L_2)(V_2 - V_T)^2$$

Selon l'invention, on souhaite que :

$$(13) \quad I_{OL2} = I_{OL1} = I_{OL} = \text{Constante}$$

$$(14) \quad V_{OL2} = V_{OL1} = V_{OL} = \text{Constante}$$

Tout en satisfaisant la relation suivante :

$$(15) \quad I_{SAT2} = N \ I_{SAT1}$$

car l'on souhaite allonger le temps de décharge $T_{FALL}$, N étant un nombre inférieur à 1 (compris entre 0 et 1). En combinant les relations (9) (11) (13) et (14), il vient :

$$(16) \quad K_P(W_1/L_1)(V_{CC} - V_T) V_{OL} = K_P(W_2/L_2)(V_2 - V_T) V_{OL}$$

Soit :

$$(17) \quad V_2 - V_T = (W_1/L_1)(L_2/W_2)(V_{CC} - V_T)$$

En combinant les relations (10) (12) et (15) :

$$(18) \quad (W_2/L_2)(V_2 - V_T)^2 = N \ (W_1/L_1)(V_{CC} - V_T)^2$$

En injectant la relation (17) dans la relation (18) :

$$(19) \quad (W_2/L_2)[(W_1/L_1)(L_2/W_2)(V_{CC} - V_T)]^2 = N \ (W_1/L_1)(V_{CC} - V_T)^2$$

Soit :

$$(20) \quad W_2/L_2 = (1/N)(W_1/L_1)$$

En injectant la relation (20) dans la relation (17), il vient :

$$(21) \quad V_2 - V_T = N \ (V_{CC} - V_T)$$

Ainsi, selon l'invention, le fait de diminuer la tension différentielle de grille $V_{CC}$-$V_T$ par le facteur N, pour obtenir une tension différentielle de grille $V_2$-$V_T$ répondant à la relation (21), et le fait d'augmenter parallèlement par le facteur inverse 1/N le rapport $W_1/L_1$ d'un transistor classique, pour obtenir un rapport $W_2/L_2$ répondant à la relation (20), permet de réaliser un transistor présentant un courant de saturation $I_{SAT2}$ diminué par le facteur N relativement au courant de saturation $I_{SAT1}$ du transistor conventionnel, tout en conservant le point de fonctionnement $P_{OL}$ ($V_{OL}$, $I_{OL}$) du transistor conventionnel, imposé par les spécifications industrielles.

La figure 2 représente la courbe courant/tension C3 d'un tel transistor. La courbe C3 présente un courant de saturation $I_{SAT2}$ très inférieur au courant $I_{SAT1}$ (partie plate de la courbe) mais conserve une partie linéaire identique à la partie linéaire de la courbe C1, quand la tension drain-source $V_{DS}$ est comprise entre $V_{OL}$ et $V_2$-$V_T$ . Un tel transistor limite le courant de saturation qui assure une grande partie de la décharge de la capacité $C_{BUS}$. L'augmentation du temps $T_{FALL}$ est égale au rapport entre l'aire délimitée par la courbe C1 entre les tensions $V_{OL}$, $V_1$ et l'aire délimitée par la courbe C3 entre les tensions $V_{OL}$, $V_1$.

**Exemple de réalisation d'un étage de sortie selon l'invention.**

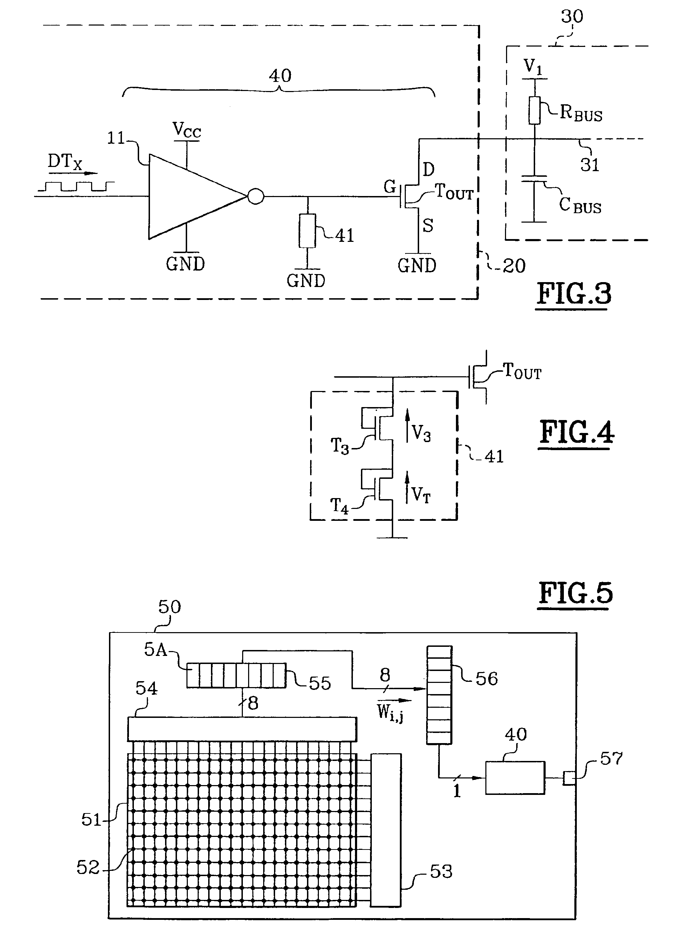

La figure 3 représente un étage de sortie 40 selon l'invention. L'étage de sortie 40 est quasiment identique à l'étage 10 de la figure 1 à la différence qu'un circuit de polarisation selon l'invention, représenté sous la forme d'un bloc 41, est connecté entre la grille du transistor $T_{OUT}$ et la masse. Quand le transistor $T_1$ de la porte inverseuse 11 est passant, le circuit 41 régule la grille du transistor et impose une tension $V_2$ répondant à la relation (21) ci-dessus, N étant choisi pour obtenir un temps $T_{FALL}$ ne générant pas un bruit de commutation indésirable, $T_{FALL}$ étant de préférence supérieur à 20 ns.

Selon un mode de réalisation avantageux illustré sur la figure 4, le circuit de polarisation 41 comprend en série un élément T3 et un transistor T4 agencé en diode, le transistor T4 étant de même structure et dimensions que le transistor $T_{OUT}$. Dans ces conditions, la tension $V_2$ aux bornes du circuit 41, appliquée à la grille du transistor $T_{OUT}$, est égale à :

$$(22) \quad V_2 = V_3 + V_T$$

VT étant la tension de seuil du transistor diode T4 et $V_2$ une tension apparaissant aux bornes de l'élément T3.

Avec cet agencement, les variations en température de la tension de seuil $V_T$ du transistor $T_{OUT}$ sont partiellement compensées par la tension $V_2$, la tension de seuil $V_T$ du transistor T4 étant identique et évoluant de la même manière que la tension de seuil $V_T$ du transistor $T_{OUT}$. Ainsi, la tension différentielle de grille $V_2$-$V_T$ du transistor $T_{OUT}$ a maintenant pour expression :

$$(23) \quad V_2 - V_T = (V_3 + V_T) - V_T = V_3$$

et ne dépend plus que de la tension $V_3$.

L'élément T3 peut être un élément de référence délivrant une tension stable en température ou, plus simplement, être un transistor NMOS natif agencé en diode dont la tension de seuil $V_{TNAT}$ est plus faible que celle d'un transistor enrichi.

Dans ces conditions, pour une tension $V_{CC}$ de l'ordre de 5V, une tension $V_T$ de 0,7 V et une tension $V_{TNAT}$ de 0,4 V, la tension $V_2$ imposée par le circuit de polarisation 41 permet de réduire d'environ 74% la tension différentielle de grille relativement à la valeur qu'elle présenterait en l'absence du circuit 41, et de diminuer dans les même proportions le courant de saturation $I_{SAT}$, comme cela ressort des calculs suivants

$$(24) \quad V_3 = V_{TNAT} + V_T = N(V_{CC} - V_T)$$

Soit :

$$(25) \quad N \; = \; (V_{TNAT} + V_T) \, / \, (V_{CC} - V_T)$$

Soit :

$$(26) \quad N = 0,26$$

Il apparaîtra clairement à l'homme de l'art que la présente invention est susceptible de diverses variantes de réalisation et applications. Par exemple, la présente invention s'applique également lorsque la résistance de polarisation du drain du transistor $T_{OUT}$ est une résistance agencée dans l'étage de sortie 10 au lieu d'être la résistance $R_{BUS}$, la tension de polarisation du drain étant alors la tension $V_{CC}$ au lieu de la tension $V_1$ (bien qu'en pratique $V_1$ et $V_{CC}$ soient généralement identiques) .

Par ailleurs, bien que le circuit de polarisation 41 soit représenté connecté à la grille du transistor $T_{OUT}$ sur la figure 3, il est également possible de placer ce circuit en un autre point de l'étage de sortie. Par exemple, la porte inverseuse 11 pourrait être alimentée par une tension régulée plus faible de la tension $V_{CC}$ et délivrer à l'état haut une tension de grille $V_{GS}$ répondant à la relation 21 ci-dessus.

Enfin, bien que le problème technique ayant conduit à la réalisation de la présente invention concerne les bus de type I2C, il est clair que la présente invention n'est pas limitée à une telle application et peut concerner toute autre ligne de transmission de données de type capacitif.

La figure 5 illustre une application de la présente invention aux mémoires programmables et effaçables électriquement, ou mémoires EEPROM, disposant d'une sortie série pour bus I2C. La mémoire EEPROM 50 représentée très schématiquement sur la figure 5 comprend un plan mémoire 51 composé de cellules mémoires 52 agencées en lignes et en colonnes, un décodeur de ligne 53, un décodeur de colonne 54 et un circuit de lecture 55 connecté au décodeur de colonne. Le circuit de lecture 55 comprend des amplificateurs de lecture SA ("sense amplifiers") pour délivrer des mots binaires $W_{i,j}$ lus dans le plan mémoire 51, ici des octets. Les mots binaires $W_{i,j}$ sont appliqués à un registre 56 à sortie série et chargement parallèle. La sortie série du registre 56 est envoyée sur une borne de sortie 57 de la mémoire 50 par l'intermédiaire d'un étage de sortie 40 conforme à celui qui vient d'être décrit.

## Revendications

1. Procédé pour allonger le temps de passage à l'état bas d'une borne (D) d'un transistor de sortie ($T_{OUT}$) de type MOS connectée à une ligne de transmission de données (31) présentant une capacité électrique déterminée ($C_{BUS}$), le passage à l'état bas de la borne (D) du transistor de sortie provoquant la décharge de la capacité électrique ($C_{BUS}$), tout en conservant un point de fonctionnement ($V_{OL}$, $I_{OL}$) à l'état bas du transistor ($T_{OUT}$) sensiblement identique, la grille du transistor étant pilotée par un circuit logique (11) présent dans un circuit intégré (20) recevant une tension d'alimentation déterminée ($V_{CC}$), procédé **caractérisé en ce qu'**il comprend une étape consistant à abaisser la tension de polarisation grille-source ($V_{GS}$) du transistor à l'état passant relativement à celle ($V_{CC}$) qui apparaîtrait naturellement à la sortie du circuit logique (11) si une telle étape n'était pas prévue, tout en augmentant le rapport (W/L) largeur sur longueur de grille du transistor pour conserver le point de fonctionnement initial à l'état bas ($V_{OL}$, $I_{OL}$) du transistor.

2. Procédé selon la revendication 1, comprenant une étape consistant à connecter la grille du transistor à un circuit de polarisation de grille (41).

3. Procédé selon la revendication 2, dans lequel le circuit de polarisation de grille est agencé pour réduire la tension à l'état haut ($V_{CC}$) délivrée par le circuit logique (11) sur la grille du transistor.

4. Procédé selon la revendication 3, **caractérisé en ce que** le circuit de polarisation de grille comprend au moins en série un premier transistor MOS (T4) monté en diode, sensiblement identique au transistor de sortie, et un transistor natif (T3) également agencé en diode.

5. Procédé selon l'une des revendications 1 à 4, dans lequel on applique au transistor de sortie une tension de polarisation grille-source ($V_{GS}$) inférieure à 2 Volt pour rendre le transistor passant.

**6.** Circuit intégré (20, 50) alimenté électriquement par une tension déterminée ($V_{CC}$) et comprenant un transistor MOS de sortie ($T_{OUT}$) dont la grille est pilotée par la sortie d'un circuit logique (11), le transistor de sortie comprenant une borne (D) qui est connectée ou destinée à être connectée à une ligne de transmission de données (31) présentant une capacité électrique ($C_{BUS}$), de telle sorte que le passage à l'état bas de la seconde borne (D) provoque une décharge de la capacité électrique ($C_{BUS}$),
**caractérisé en ce que** qu'il comprend un circuit (41) de polarisation de la grille du transistor ($T_{OUT}$) prévu pour abaisser la tension de polarisation grille-source ($V_{GS}$) du transistor à l'état passant relativement à celle ($V_{CC}$) qui serait fixée par la sortie du circuit logique (11) en l'absence d'un tel circuit de polarisation (41), le circuit de polarisati on (41) est agencé pour réduire la tension à l'état haut ($V_{CC}$) délivrée par le circuit logique (11) et comprend à cet effet au moins un premier transistor MOS (T4) agencé en diode et sensiblement identique au transistor de sortie.

**7.** Circuit intégré selon la revendication 6, dans lequel la tension de polarisation grille-source ($V_{GS}$) du transistor à l'état passant est inférieure à 2 Volt.

**8.** Circuit intégré selon l'une des revendications 6 et 7, dans lequel le circuit de polarisation comprend un transistor natif (T3) agencé en diode, en série avec le premier transistor diode (T4).

**9.** Circuit intégré selon l'une des revendications 6 à 8, **caractérisé en ce que** le transistor de sortie ($T_{OUT}$) présente un rapport (W/L) largeur (W) sur longueur (L) de grille lui conférant un point de fonctionnement à l'état bas ($P_{OL}$, $V_{OL}$, $I_{OL}$) conforme aux spécifications des bus I2C et un temps de descente ($T_{FALL}$) du signal de sortie au moins égal à 20 nanosecondes.

**10.** Circuit intégré selon l'une des revendications 6 à 9, **caractérisé en ce qu'**il prend la forme d'une mémoire EEPROM (50) et **en ce que** l'étage de sortie (40) est agencé pour délivrer des données ($W_{i,j}$) lues dans la mémoire.

## Claims

**1.** A method for extending the time taken by a terminal (D) of a MOS-type output transistor ($T_{OUT}$) connected to a data transmission line (31) having a determined electric capacitance ($C_{BUS}$) to change to the low state, the change of the terminal (D) of the output transistor to the low state causing the discharge of the electric capacitance ($C_{BUS}$), while keeping a substantially identical low state operating point ($V_{OL}$, $I_{OL}$) of the transistor ($T_{OUT}$), the gate of the transistor being driven by a logic circuit (11) present in an integrated circuit (20) receiving a determined supply voltage ($V_{CC}$), a method **characterized in that** it comprises a step of reducing the gate-source bias voltage ($V_{GS}$) of the transistor in the transmission state in relation to the voltage ($V_{CC}$) which would naturally appear at the output of the logic circuit (11) if such a step were not provided, while increasing the gate width-to-length ratio (W/L) of the transistor in order to keep the initial low state operating point ($V_{OL}$, $I_{OL}$) of the transistor.

**2.** Method according to claim 1, comprising a step of connecting the gate of the transistor to a gate bias circuit (41).

**3.** Method according to claim 2, wherein the gate bias circuit is arranged to reduce the high state voltage ($V_{CC}$) delivered on the gate of the transistor by the logic circuit (11).

**4.** Method according to claim 3, **characterized in that** the gate bias circuit comprises at least in series a first diode-mounted MOS transistor (T4), substantially identical to the output transistor, and a native transistor (T3), also diode-arranged.

**5.** Method according to one of claims 1 to 4, wherein a gate-source bias voltage ($V_{GS}$) of less than 2 Volts is applied to the output transistor in order to put the transistor into the transmission state.

**6.** An integrated circuit (20, 50) electrically powered by a determined voltage ($V_{CC}$) and comprising an output MOS transistor ($T_{OUT}$) the gate of which is driven by the output of a logic circuit (11), the output transistor comprising a terminal (D) which is connected or intended to be connected to a data transmission line (31) having an electric capacitance ($C_{BUS}$), such that the change of the second terminal (D) to the low state causes a discharge of the electric capacitance ($C_{BUS}$),
**characterized in that** it comprises a circuit (41) for biasing the gate of the transistor ($T_{OUT}$) provided for reducing the gate-source bias voltage ($V_{GS}$) of the transistor in the transmission state relative to the voltage ($V_{CC}$) that would be fixed by the output of the logic circuit (11) in the absence of such a bias circuit (41), the bias circuit (41) is arranged for reducing the high state voltage ($V_{CC}$) delivered by the logic circuit (11) and comprises for that purpose at least a first MOS transistor (T4), diode-arranged and substantially identical to the output transistor.

7. Integrated circuit according to claim 6, wherein the gate-source bias voltage ($V_{GS}$) of the transistor in the transmission state is less than 2 Volts.

8. Integrated circuit according to one of claims 6 and 7, wherein the bias circuit comprises a native transistor (T3), diode-arranged, in series with the first diode transistor (T4).

9. Integrated circuit according to one of claims 6 to 8, **characterized in that** the output transistor ($T_{OUT}$) has a gate width-(W)to-length (L) ratio (W/L) which gives it a low state operating point ($P_{OL}$, $V_{OL}$, $I_{OL}$) conforming to the I2C bus specifications and a fall time ($T_{FALL}$) of the output signal at least equal to 20 nanoseconds.

10. Integrated circuit according to one of claims 6 to 9, **characterized in that** it takes the form of an EEPROM memory (50) and **in that** the output stage (40) is arranged for delivering data ($W_{i,j}$) read in the memory.

**Patentansprüche**

1. Verfahren zum Verlängern der Übergangszeit auf niedrigen Zustand einer Klemme (D) eines Ausgangstransistors ($T_{OUT}$) des Typs MOS, die an eine Datenübertragungsleitung (31) angeschlossen ist, die eine bestimmte Kapazität ($C_{BUS}$) aufweist, wobei der Übergang auf den niedrigen Zustand der Klemme (D) des Ausgangstransistors das Entladen der Kapazität ($C_{BUS}$) verursacht und gleichzeitig einen Betriebspunkt ($V_{OL}$, $I_{OL}$) auf dem niedrigen Zustand des Transistors ($T_{OUT}$) im Wesentlichen identisch hält, wobei die Gate-Elektrode des Transistors von einer Logikschaltung (11) gesteuert wird, die in einem integrierten Schaltkreis (20) gegenwärtig ist, der eine bestimmte Versorgungsspannung ($V_{CC}$) erhält, Verfahren **dadurch gekennzeichnet, dass** es einen Schritt aufweist, der darin besteht, die Gate-Source-Polarisierungsspannung ($V_{GS}$) des Transistors im durchlässigen Zustand in Bezug auf die ($V_{CC}$) zu senken, die naturgemäß am Ausgang der Logikschaltung (11) auftreten würde, wenn ein derartiger Schritt nicht vorgesehen wäre, und gleichzeitig das Verhältnis (W/L) Breite zu Länge der Gate-Elektrode zu erhöhen, um den ursprünglichen Betriebspunkt auf niedrigem Zustand ($V_{OL}$, $I_{OL}$) des Transistors beizubehalten.

2. Verfahren nach Anspruch 1, das einen Schritt aufweist, der darin besteht, die Gate-Elektrode des Transistors mit einem Gate-Polarisierungsschaltkreis (41) zu verbinden.

3. Verfahren nach Anspruch 2, bei dem der Gate-Polarisierungsschaltkreis eingerichtet ist, um die Spannung in hohem Zustand ($V_{CC}$), die von der Logikschaltung (11) auf die Gate-Elektrode des Transistors geliefert wird, zu verringern.

4. Verfahren nach Anspruch 3, **dadurch gekennzeichnet, dass** der Gate-Polarisierungsschaltkreis mindestens in Serie einen ersten MOS-Transistor (T4) aufweist, der als Diode installiert ist, der im Wesentlichen mit dem Ausgangstransistor identisch ist, und einen nativen Transistor (T3), der ebenfalls als Diode eingerichtet ist.

5. Verfahren nach einem der Ansprüche 1 bis 4, bei dem man auf den Ausgangstransistor eine Gate-Quellen-Polarisierungsspannung ($V_{GS}$) anlegt, die kleiner als 2 Volt ist, um den Transistor durchlässig zu machen.

6. Integrierter Schaltkreis (20, 50), der elektrisch von einer bestimmten Spannung ($V_{CC}$) versorgt wird und einen MOS-Ausgangstransistor ($T_{OUT}$) aufweist, dessen Gate-Elektrode von dem Ausgang einer Logikschaltung (11) gesteuert wird, wobei der Ausgangstransistor eine Klemme (D) aufweist, die an eine Datenübertragungsleitung (31) angeschlossen ist oder bestimmt ist, an diese angeschlossen zu werden, welche eine Kapazität ($C_{BUS}$) derart aufweist, dass das Übergehen auf den niedrigen Zustand der zweiten Klemme (D) ein Entladen der Kapazität ($C_{BUS}$) verursacht,
**dadurch gekennzeichnet, dass** er einen Gate-Elektroden-Polarisierungsschaltkreis (41) des Transistors ($T_{OUT}$) aufweist, der vorgesehen ist, um die Gate-Quellen-Polarisierungsspannung ($V_{GS}$) des Transistors im durchlässigen Zustand in Bezug auf die ($V_{CC}$) zu senken, die von dem Ausgang der Logikschaltung (11) beim Fehlen eines solchen Polarisierungsschaltkreises (41) festgelegt würde, wobei der Polarisierungsschaltkreis (41) eingerichtet ist, um die Spannung im hohen Zustand ($V_{CC}$), die von der Logikschaltung (11) geliefert wird, zu verringern, und dazu mindestens einen ersten MOS-Transistor (T4) aufweist, der als Diode eingerichtet und im Wesentlichen mit dem Ausgangstransistor identisch ist.

7. Integrierter Schaltkreis nach Anspruch 6, bei dem die Gate-Quellen-Polarisierungsspannung ($V_{GS}$) des Transistors im durchlässigen Zustand kleiner als 2 Volt ist.

8. Integrierter Schaltkreis nach einem der Ansprüche 6 und 7, bei dem der Polarisierungsschaltkreis einen nativen Transistor (T3), der als Diode eingerichtet ist, in Serie mit dem ersten Dioden-Transistor (T4) geschaltet aufweist.

9. Integrierter Schaltkreis nach einem der Ansprüche 6 bis 8, **dadurch gekennzeichnet, dass** der Ausgangstransistor ($T_{OUT}$) ein Verhältnis (W/L) Breite (W) zu Länge (L) des Gates aufweist, das ihm einen Betriebspunkt im niedrigen Zustand ($T_L$, $V_{OL}$, $I_{OL}$) gemäß den Spezifikationen der Busse I2C und eine Abfallzeit ($T_{FALL}$) des Ausgangssignals mindestens gleich 20 Nanosekunden verleiht.

10. Integrierter Schaltkreis nach einem der Ansprüche 6 bis 9, **dadurch gekennzeichnet, dass** er die Form eines EEPROM-Speichers (50) annimmt, und dass die Ausgangsstufe (40) eingerichtet ist, um Daten ($W_{i,j}$) zu liefern, die in einem Speicher gelesen werden.

**FIG.1**

**FIG.2**

**FIG.3**

**FIG.4**

**FIG.5**